**Europäisches Patentamt**

**European Patent Office**

**Office européen des brevets**

(19)

(11) Numéro de publication: **0214978**
**B1**

(12) # FASCICULE DE BREVET EUROPEEN

(45) Date de publication du fascicule du brevet:
**17.11.88**

(51) Int. Cl.⁴: **C 23 C 16/32, C 23 C 30/00**

(21) Numéro de dépôt: **85902568.6**

(22) Date de dépôt: **03.06.85**

(86) Numéro de dépôt international:
**PCT/FR 85/00136**

(87) Numéro de publication internationale:
**WO 86/00345 (16.01.86 Gazette 86/2)**

(54) **PROCEDE DE REALISATION DE REVETEMENTS DE CARBURES DE BORE ET REVETEMENTS OBTENUS.**

(30) Priorité: **27.06.84 FR 8410290**

(43) Date de publication de la demande:
**25.03.87 Bulletin 87/13**

(45) Mention de la délivrance du brevet:
**17.11.88 Bulletin 88/46**

(84) Etats contractants désignés:
**AT BE CH DE FR GB IT LI LU NL SE**

(73) Titulaire: **COATING DEVELOPPEMENT, Pôle de la Productique 74, rue des Aciéries, F-42000 Saint-Etienne (FR)**

(72) Inventeur: **DUCARROIR, Michel, Maison Solaire No. 1, Le Castelia F-66120 Odeillo (FR)**
Inventeur: **MALE, Germain, Chalet Esperansa Rue du Bosquet, F-66800 Saillagousse (FR)**
Inventeur: **NADAL, Marcel, 10, rue Jean Guiter, F-66510 Saint Hippolyte (FR)**
Inventeur: **BASSE, Alain, Rue Boileau, F-64000 Pau (FR)**
Inventeur: **PIZZINI, Gérard, 12, rue du 1er Mai, F-64000 Pau (FR)**
Inventeur: **CAZAJOUS, Didier, Lanne, F-65380 Ossun (FR)**

(74) Mandataire: **Barre, Philippe, Cabinet Barre-Gatti-Laforgue 95 rue des Amidonniers, F-31069 Toulouse Cédex (FR)**

(56) Documents cités:
**US - A - 3 967 029**
**Journal of the Less-Common Metals, vol. 23, no. 1, January 1971, Elsevier Sequoia S.A. Lausanne CH., K. Ploog et al.: "Kohlenstoff-induzierte gitter beim Bor:I-tetragonales(B12)4B2C and (B12)4B2C2", pp. 33-42**
**Journal of the Less-Common Metals, col. 82, no. 1/2, November/December 1981, Elsevier Sequoia NL, L. Vandenbulcke et al.: "Composition and structural changes of boron carbides deposited by chemical vapour deposition under various conditions of temperature and supersaturation", pp. 49-54**
**Journal of Electrochemical Society, vol. 123, no. 1, January 1976, M. Ducarroir et al.: "Thermodynamic**

(56) Documents cités: (suite)
**domains of the various solid deposits in the B-C-H-Cl vapor system", pp. 136-140**
**Chemical Abstracts, vol. 74, Columbus, Ohio, US, E. Amberger et al.: "Formation of modifications of boron and boron carbides", p. 410, abstract 131438z**
**Chemical Abstracts, vol. 100, no. 2, 9. January 1984, Columbus, Ohio, US, L. Vandenbulcke et al.: "Theoretical influence of the deposition conditions on the uniformity of boron carbide coatings, p. 295, abstract 11522f**
**Chemical Abstracts, vol. 98, no. 12, 21. March 1983, Columbus, Ohio, US, K. Voigt et al. 1"CVD-coating of hard metal with special consideeration of boron and boron compounds", p. 292, abstract 94 371v**

## Description

L'invention concerne un procédé de réalisation de revêtements de carbures de bore sur la surface d'un substrat.

L'invention s'applique en particulier pour l'obtention de pièces de coupe ou d'usure bénéficiant d'excellentes propriétés de dureté et de résistance à l'abrasion et à l'érosion.

Il est connu de revêtir des pièces de nature et de forme diverses au moyen de revêtements céramiques [TiC, TiN, Ti(CN), $Al_2O_3$] en vue d'accroître leur résistance à l'érosion et à l'abrasion. Toutefois, la dureté de ces revêtements demeure insuffisante pour certaines applications, en particulier dans le cas d'outils de forage.

En outre, pour réaliser des pièces résistant à l'érosion, il est connu d'utiliser le carbure de bore $B_4C$ sous forme frittée; la dureté de ces pièces massives est notablement améliorée par rapport aux revêtements précités mais ces pièces sont extrêmement fragiles et leur résilience (caractérisant leur résistance au choc) est incompatible avec une utilisation de ces pièces comme outil de coupe.

Par ailleurs certains travaux de laboratoire font état de la préparation de composés du système bore/carbone par des dépôts en phase vapeur en faisant réagir un composé de bore et un composé de carbone, sous forme gazeuse [A.M. MOORE, H.F. VOLK: Final report AMMRC CR 69-10 (1969) Union Carbide Corporation carbon products division, Parma OHIO; A.A. Cochran, J.B. Stephenson, J.G. Donaldson J. of Métals, 22 (1970) pp 37-42; K. PLOOG J. Less Common Métals 35 (1974) pp 115-145; L. Vandeubulcke et coauteurs J. Less Common Métals 82 (1981) pp 49-56, 80 (1981) pp 7-22].

Dans ces travaux, le dépôt est réalisé à flux gazeux élevé (supérieur à $1 \cdot 10^{-3} g \cdot cm^{-2} \cdot s^{-1}$) le plus souvent à la pression atmosphérique et à haute température; leur but est une étude du système bore-carbone ou la préparation de carbure de bore de composition proche de $B_4C$.

Une application récente de ce type de revêtement ($B_4C$) est décrite dans le brevet US n° 4 287 259 et consiste à réaliser le dépôt sur des tissus de fibres de graphite afin d'améliorer leur inertie chimique et leur résistance à la corrosion en vue d'une utilisation dans l'industrie nucléaire. Dans cette application, le dépôt obtenu en phase vapeur est constitué par une phase amorphe dont la teneur atomique en carbone se situe autour de 30%.

Dans certains secteurs techniques et notamment dans l'industrie des forages, il est souhaitable, en fonction de l'application envisagée, d'obtenir le meilleur compromis dureté/résilience afin que le revêtement bénéficie d'une dureté élevée (supérieure à celle des revêtements connus), tout en présentant une résistance au choc adaptée à l'application.

En conséquence, la présente invention vise à fournir un nouveau revêtement de carbures de bore sur substrat massif, dont la dureté soit notablement supérieure à celle des revêtements industriels connus et comprise entre environ 3 200 et 5 100 kg/mm² (micro-dureté Knoop déterminée par micro- duromètre «OLP» équipé d'une pyramide de Knoop sous une charge de 100 g; par la suite, on se référera toujours à cette définition de la dureté qui sera notée $HK_{0,1}$).

Un objectif essentiel de l'invention est d'autoriser un ajustement précis de la dureté du revêtement dans cette plage en fonction de l'application envisagée, de façon à obtenir le meilleur compromis dureté/résilience pour cette application.

A cet effet, le procédé de l'invention permettant d'ajouter la dureté d'un revêtement de carbure de bore dans une plage de dureté approximativement comprise entre 3 200 et 5 100 kg/mm² (micro-dureté $HK_{0,1}$) consiste à réduire un mélange gazeux d'au moins un composé de bore et d'au moins un composé de carbone, en présence d'un substrat dont la surface est chauffée à une température comprise entre 800° et 1 200°C; selon la présente invention, ce procédé se caractérise en ce que:

. l'on amène le mélange gazeux à balayer la surface du substrat à une pression totale inférieure ou égale à 100 millibars, avec un flux massique moyen compris entre $10^{-4}$ et $10^{-3} g \cdot cm^2 \cdot s^-$, de façon à déposer un revêtement constitué par une des phases ou un mélange des phases cristallines suivantes: phase de structure quadratique $B_{50}C_2$, phase de structure rhomboédrique $B_{13}C_2$.

. l'on établit préalablement la courbe de variation de la durée du revêtement en fonction de la composition du mélange gazeux en composé de carbone et composé de bore, pour les conditions de température, pression et flux massique choisies, puis l'on détermine la valeur de la composition correspondant à la dureté recherchée,

. l'on ajoute la composition du mélange gazeux à la valeur ainsi déterminée.

Dans le cas de l'utilisation d'un mélange gazeux de trichlorure de bore et de méthane, la réaction est effectuée en présence d'hydrogène en quantité nécessaire pour assurer la réduction; le rapport atomique C/B est ajusté à la valeur appropriée en fonction de la dureté désirée, en particulier dans une plage comprise entre environ 0,05 et 6, en réglant le débit de méthane Dc et le débit de trichlorure de bore Db. En pratique on ajustera le rapport

$$R = \frac{100 \cdot Dc}{Db + Dc}$$

à une valeur comprise entre 5 et 85, fonction croissante de la dureté désirée.

La réaction globale qui se déroule à la surface du substrat est la suivante:

$$x\,B\,Cl_3 + CH_4 + [3/2x - 2]\,H_2 \rightarrow \underline{B_x C} + 3x\,\overline{H\,Cl}$$

L'analyse du carbure de bore précitée (BxC), effectuée par diffraction des rayons X, montre que les conditions de mise en œuvre à pression réduite avec des flux faibles du mélange gazeux initial permettent, dans la plage de température précitée, d'obtenir deux phases cristallines, l'une quadratique dont la composition est proche de $B_{50}C_2$, l'autre rhomboédrique dont la composition est proche de $B_{13}C_2$; on a pu constater que ces phases possédaient des compositions variables autour de celles correspondant aux deux formules précitées. Une variation du rapport R concernant les débits de gaz du mélange initial permet de faire varier, d'une part, la composition de ces phases, d'autres part, leur proportion relative; la dureté du revêtement obtenu est fonction de ces compositions et proportions et peut ainsi être ajustée par l'opérateur.

En outre on a pu constater que des variations du flux massique du mélange gazeux initial dans la plage sus-évoquée ou de la pression au dessous de la valeur indiquée n'affectent pas de façon sensible la composition du dépôt.

Les figures des dessins annexés présentent des diagrammes illustrant les résultats obtenus:

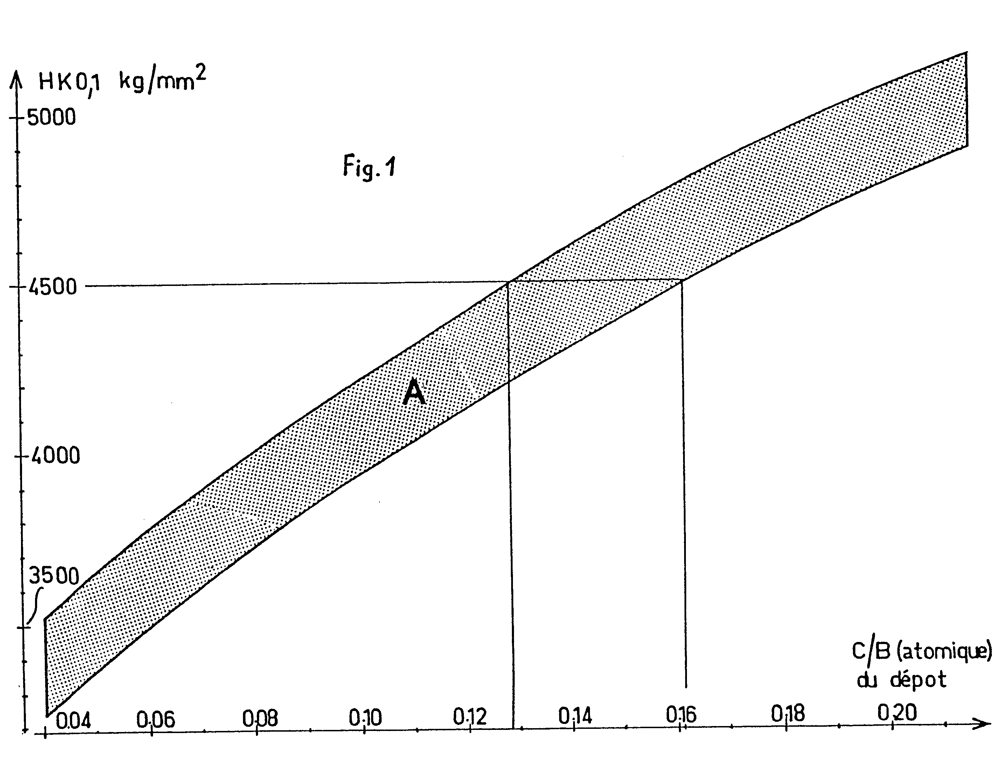

. la figure 1 est un diagramme donnant la dureté $HK_{0,1}$ des revêtements obtenus en fonction du rapport atomique C/B de ceux-ci,

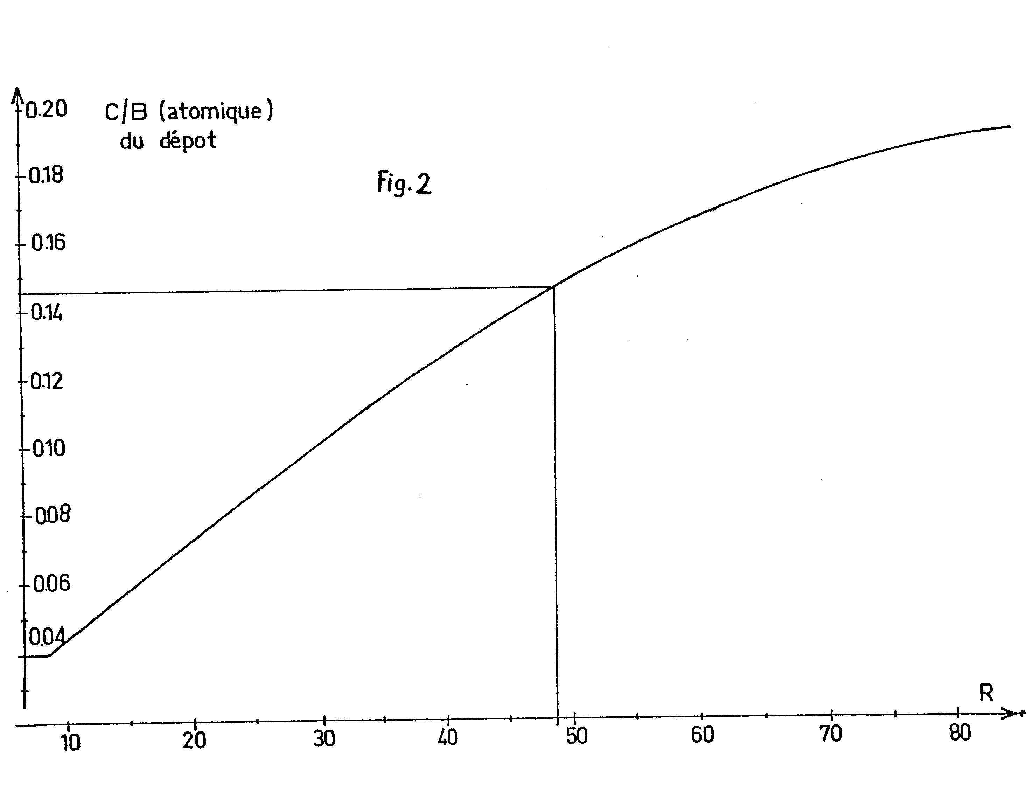

. la figure 2 illustre, à titre d'exemple, les variations du rapport atomique C/B des revêtements en fonction du rapport

$$R = \frac{100 \cdot Dc}{Dc + Db}$$

des débits de gaz initiaux, pour une température donnée (1 125°C).

Comme l'illustre la figure 1, la dureté du dépôt constitué par l'une ou l'autre des phases cristallines précitées ou par leur mélange, est une fonction croissante de la teneur en carbone de ce dépôt.

L'incertitude sur les résultats expérimentaux conduit à une zone A à l'intérieur de laquelle sera choisi le rapport C/B en fonction de la dureté désirée.

Cette dernière varie entre environ 3 200 et 5 100 kg/mm² (microdureté $HK_{0,1}$) pour un rapport atomique C/B variant entre 0,04 et 0,22. Les valeurs C/B voisines de 0,04 correspondent à l'obtention de la seule phase quadratique $B_{50} C_2$, dont la composition est faiblement variable. Les valeurs C/B supérieures à 0,04 jusqu'à environ 0,12 correspondent à un mélange des phases quadratique $B_{50}C_2$ et rhomboédrique $B_{13}C_2$. Les valeurs comprises entre 0,12 et 0,22 correspondent à la seule phase $B_{13}C_2$, phase à grand domaine d'homogénéité dont la composition possède donc une large plage de variations.

La figure 2 illustre les variations du rapport C/B du revêtement en fonction du rapport

$$R = \frac{100 \cdot Dc}{Db + Dc}$$

dans le cas d'un procédé en phase vapeur utilisant un flux gazeux de méthane, trichlorure de bore et hydrogène. Ce rapport R est le paramètre essentiel qui définit la nature, la proportion et la composition des phases et, par voie de conséquence les propriétés mécaniques du dépôt.

La figure 2 illustre les résultats obtenus pour une mise en œuvre à la température de 1 125°C; cette courbe se déplace avec la température et sera donc expérimentalement tracée dans chaque application en fonction de la température choisie pour effectuer le dépôt.

Les autres conditions de mise en œuvre (pression, flux massique) ont une influence négligeable mais doivent être comprises dans les plages définies précédemment.

Si l'on suppose par exemple que le meilleur compromis dureté/résilience correspond à une dureté de 4 500 kg/mm², le rapport C/B du revêtement à réaliser doit être compris entre environ 0,13 et 0,16; l'on peut choisir une valeur moyenne de 0,145 (figure 1).

En utilisant une température de 1 125°C un tel revêtement est obtenu avec un rapport R de l'ordre de 50 (figure 2). Il est ainsi facile d'ajuster les conditions opératoires, pour obtenir la dureté désirée. (Dans cet exemple, le revêtement obtenu est constitué par la phase rhomboédrique de composition variable $B_{13}C_2$).

Le dépôt peut être effectué sur tout substrat adapté à l'application, qui est apte à supporter la température de mise en œuvre; il est à noter que la plage de température de mise en œuvre (800°C - 1 200°C) permet de revêtir des substrats tels que le carbure de tungstène ou les aciers sans affecter leur structure de façon irréversible.

Le dépôt peut être fait directement sur le substrat ou avec interposition d'une barrière de diffusion à la surface de celui-ci. Cette barrière constituée en particulier par du carbure de titane, nitrure de titane, carbure de silicium,... supprime les interactions chimiques ou physico-chimiques entre le substrat et le revêtement.

Il est possible d'obtenir par le procédé de l'invention des pièces massives en carbure de bore. Le revêtement est alors réalisé avec une épaisseur lui permettant de présenter une tenue mécanique propre suffisante (épaisseur supérieure à 100 microns); après dépôt, l'on sépare le revêtement du substrat en vue d'obtenir la pièce massive désirée. Dans ce cas le substrat sera de préférence choisi de façon à développer une faible adhérence avec le revêtement (graphite, nitrure de bore); la séparation peut s'effectuer par destruction chimique ou mécanique du substrat notamment dans le cas de pièces creuses.

Les exemples 1 à 4 qui suivent illustrent le procédé de l'invention; tous ces exemples ont été réalisés en phase vapeur au moyen d'un flux gazeux comprenant du méthane, du trichlorure de bore et de l'hydrogène en excès.

*Exemple 1*

*Dépôt direct de carbures de bore sur des substrats de carbure de tungstène fritté avec du cobalt comme liant*

Paramètres: T = 1 020°C,
    pression totale $P_T$ = 10 mbar
    $Db(BCl_3)$ = 1,5 l · h⁻¹, $Dc(CH_4)$ = 1 l · h⁻¹
    $D(H_2)$ = 5 l · h⁻¹, R = 40, durée: $\Delta t$ = 150 mn
Flux massique du mélange gazeux:
    $4 \cdot 10^{-4}$ g · cm⁻² · s⁻¹

Substrat: [WC + Co 15%]

Epaisseur du dépôt: 36-40 µm

Dureté moyenne ($HK_{0,1}$)
Dépôt = $3800 \pm 150$ kg $\cdot$ mm$^{-2}$
Substrat: $1260 \pm 40$ kg $\cdot$ mm$^{-2}$.

Il est à noter que dans ce cas, le bore provenant de la réaction diffuse dans le substrat et forme une sous-couche de borure de cobalt (B Co) qui entoure les grains de carbure de tungstène. L'épaisseur de cette sous-couche intermédiaire entre le revêtement proprement dit et le substrat varie avec la durée de traitement et la teneur en cobalt du substrat. La dureté de cette sous-couche est intermédiaire entre celle du substrat et celle du revêtement, en l'exemple de l'ordre de $1430$ kg/mm$^2$. La couche de carbures de bore qui se développe au-dessus est dense (taux de porosités très faible) et macroscopiquement homogène.

L'interface entre le revêtement et la sous-couche est constituée d'une couche de BCo pur de 1 à 2 µm d'épaisseur. La morphologie de la sous-couche dépend de la teneur en Co du substrat. Le cobalt diffuse en effet vers la surface en créant de nombreuses porosités par effet Kirkendal dans le cas des fortes teneurs (30%). Les porosités s'atténuent ou même disparaissent dans le cas de faibles teneurs en cobalt du substrat (15%).

La diffraction des rayons X (RX) donne le spectre du diphasé $B_{50}C_2 + B_{13}C_2$ pour le revêtement.

## Exemple 2

*Dépôt de carbures de bore sur des pièces en carbure de tungstène fritté avec interposition d'une barrière de diffusion*

La diffusion du bore vers le substrat est arrêtée par le dépôt préalable d'une couche de carbure de titane (TiC) de quelques microns.

Le dépôt de carbures de bore s'effectue alors comme sur un substrat non réactif.

Substrat [WC + Co 7%] + TiC (10 µm)
T = $1020°$C, $P_T$ = 10 mbar
Db = 1,5 l/h, Dc = 1 l/h
Flux massique: $4 \cdot 10^{-4}$ g $\cdot$ cm$^{-2} \cdot$ s$^{-1}$
R = 40, $D(H_2)$ = $5$ l $\cdot$ h$^{-1}$ $\Delta t$ = 150 mn
Epaisseur du dépôt: 30 µm
Dureté $HK_{0,1}$ du dépôt: $3800 \pm 150$ kg/mm$^2$.

## Exemple 3

*Substrat constitué par l'acier avec barrière de diffusion*

Substrat acier 35 CD 4 + TiC (0,5-1 µm)
T = $980°$C      P = 10 mbar
Db = 1 l/h      Dc = 1 l/h
Flux massique: $2,89 \cdot 10^{-4}$ g $\cdot$ cm$^{-2} \cdot$ s$^{-1}$
R = 50      $D(H_2)$ = $5$ l $\cdot$ h$^{-1}$      $\Delta t$ = 45 mn
Epaisseur de dépôt: 8-10 µm
Dureté $HK_{0,1}$: $3500 \pm 150$ kg/mm$^2$

## Exemple 4

*Dépôt de carbure de bore sur substrat non réactif*

Le substrat étant du graphite, on a effectué plusieurs expérimentations en faisant varier le rapport R et en conservant une même température ($1125°$C), une même pression totale de mise en œuvre (10 mbar) et un même débit d'hydrogène ($5$ l $\cdot$ h$^{-1}$). Sont fournies ci-après les conditions opératoires complémentaires et les caractéristiques obtenues pour trois de ces expérimentations.

1./ - R = 9
Db = $1,5$ l $\cdot$ h$^{-1}$; Dc = $0,15$ l $\cdot$ h$^{-1}$.
Flux gazeux: $3,79 \cdot 10^{-4}$ g $\cdot$ cm$^{-2} \cdot$ s$^{-1}$.
Dureté $HK_{0,1}$ = $3400 \pm 150$ kg $\cdot$ mm$^{-2}$
Phases (R''X'') = $B_{50}C_2$

2./ - R = 28,6
Db = $1,5$ l $\cdot$ h$^{-1}$; Dc = $0,61$ l $\cdot$ h$^{-1}$.
Flux = $3,94 \cdot 10^{-4}$ g $\cdot$ cm$^{-2} \cdot$ s$^{-1}$.
Dureté $HK_{0,1}$ = $3900 \pm 150$ kg $\cdot$ mm$^{-2}$
Phases (R''X'') = $B_{13}C_2 + B_{50}C_2$

3./ - R = 60
Db = $1,3$ l $\cdot$ h$^{-1}$; Dc = $2$ l $\cdot$ h$^{-1}$.
Flux = $3,92 \cdot 10^{-4}$ g $\cdot$ cm$^{-2} \cdot$ s$^{-1}$.
Dureté $HK_{0,1}$ = $4650 \pm 150$ kg $\cdot$ mm$^{-2}$
Phases (R''X'') = $B_{13}C_2$.

Par ailleurs l'exemple 5 qui suit donne les résultats comparatifs d'essais de forage avec des substrats nus et des substrats revêtus conformément au procédé de l'invention.

## Exemple 5

*Essais de forage comparatif*

Il a été réalisé des tests de forage comparatifs en cellule d'essai pour mettre en évidence l'influence du dépôt de Carbure de Bore sur les paramètres de forage (vitesse et métrage).

Les essais ont été effectués avec, d'une part, des pastilles de Carbure de Tungstène liant cobalt et, d'autre part, des pastilles analogues revêtues avec le Carbure de Bore.

Les dépôts de Carbures de Bore ont été réalisés dans les conditions suivantes:

— Sur pastilles I
(WC = 94%) - Co = 5,5% - Tac = 0,5%)

— Sur pastilles II
(WC = 88%) - Co = 9%    - Tac = 3%)

T      = $1020°$C
Pt      = 1 mbar
Db      = $12$ l $\cdot$ h$^{-1}$
Dc      = $8$ l $\cdot$ h$^{-1}$
Dh2      = $30$ l $\cdot$ h$^{-1}$
R      = 40
t      = 180 mn.

Les conditions d'essai ont été les suivantes:

— Débit: 40 l/mn (débit de fluide du forage)
— Rotation: 750 T/mn
— Poids de l'outil: 425 kg
— Roche forée: pierre bleue ou petit granit.

Le forage a été arrêté dans le cas des pastilles non revêtues lorsque la vitesse d'avancement était inférieure à 5 cm/mn. Dans le cas des pastilles revêtues de carbure de Bore, le forage a été arrêté lorsque la vitesse d'avancement était inférieure à 8 cm/mn, cest-à-dire lorsque le revêtement se trouvait usé et que l'on pouvait considérer que le forage s'effectuait avec le seul substrat.

| PASTILLES | I non revêtus | I avec revêtement | II non revêtus | II avec revêtement |
|---|---|---|---|---|
| Temps de forage | 11 mn 25 s | 15 mn 23 s | 6 mn 30 s | 13 mn 26 s |
| Métrage foré | 110 cm | 457 cm | 50 cm | 353 cm |
| Vitesse moyenne d'avancement | 9,64 cm/mn | 29,71 cm/mn | 9,09 cm/mn | 26,28 cm/mn |
| Vitesse maximum enregistrée | 15 cm/mn | 46 cm/mn | 12,5 cm/mn | 49,4 cm/mn |

## Revendications

1. Procédé d'ajustement de la dureté d'un revêtement de carbure de bore dans une plage de dureté approximativement comprise entre 3 200 et 5 100 kg/mm$^2$ (micro-dureté $HK_{0,1}$), ce procédé consistant à réduire un mélange gazeux d'au moins un composé de bore et d'au moins un composé de carbone, en présence d'un substrat dont la surface est chauffée à une température comprise entre 800° et 1 200°C, et étant caractérisé en ce que:

. l'on amène le mélange gazeux à balayer la surface du substrat à une pression totale inférieure ou égale à 100 millibars, avec un flux massique moyen compris entre 10$^{-4}$ et 10$^{-3}$ g · cm$^2$ · s$^{-1}$, de façon à déposer un revêtement constitué par une des phases ou un mélange des phases cristallines suivantes: phase de structure quadratique $B_{50} C_2$, phase de structure rhomboédrique $B_{13}C_2$,

. l'on établit préalablement la courbe de variation de la dureté du revêtement en fonction de la composition du mélange gazeux en composé de carbone et composé de bore, pour les conditions de température, pression et flux massique choisies, puis l'on détermine la valeur de la composition correspondant à la dureté recherchée,

. l'on ajuste la composition du mélange gazeux à la valeur ainsi déterminée.

2. Procédé selon la revendication 1, caractérisé en ce que la courbe de variation de la dureté du revêtement en fonction de la composition du mélange gazeux est établie en faisant varier ladite composition de sorte que le rapport atomique C/B du carbone et du bore en présence dans le mélange gazeux soit compris entre environ 0,05 et 6.

3. Procédé selon l'une des revendications 1 ou 2, dans lequel on utilise un mélange gazeux de trichlorure de bore et de méthane, en présence d'hydrogène en quantité adaptée pour assurer la réduction, ledit procédé étant caractérisé en ce que la courbe de variation de la dureté est établie en mélangeant des débits variables de méthane Dc et de trichlorure de bore Db, de sorte que le rapport

$$\frac{100 \cdot Dc}{Db + Dc}$$

soit compris entre 5 et 85, le revêtement possédant la dureté désirée étant ensuite obtenu en ajustant le rapport des débits à la valeur correspondant à ladite dureté.

4. Procédé selon l'une des revendications 1, 2 ou 3, dans lequel le substrat est en un matériau du groupe suivant: graphite, nitrure de bore, carbure de tungstène, acier.

5. Procédé selon l'une des revendications 1, 2, 3 ou 4, dans lequel le substrat comporte sur sa surface une barrière de diffusion, en particulier carbure de titane, nitrure de titane, carbure de silicium.

6. Procédé d'ajustement de la dureté d'une pièce en carbure de bore, consistant à réaliser sur un substrat un revêtement d'épaisseur supérieure à 100 microns, conformément à l'une des revendications précédentes, puis à séparer ledit substrat dudit revêtement en vue d'obtenir une pièce massive en carbure de bore de dureté recherchée.

## Patentansprüche

1. Verfahren zur Einstellung der Härte eines Überzugs aus Borkarbid in einem Bereich mit einer Härte ungefähr innerhalb der Spanne von 3 200 und 5 100 kg/mm$^2$ (Mikrohärte $HK_{0,1}$) wobei dieses Verfahren darin besteht, dass in Gegenwart einer Trägerschicht, deren Oberfläche auf eine Temperatur zwischen 800° und 1 200°C erhitzt ist, ein gasförmiges Gemisch von mindestens einer Borverbindung und mindestens einer Kohlenstoffverbindung reduziert wird, und dadurch gekennzeichnet,

. dass man das gasförmige Gemisch dazu bringt, dass es die Oberfläche der Trägerschicht unter einem Gesamtdruck überstreicht, der geringer oder gleich 100 Millibar ist, wobei ein mittlerer Massenfluss zwischen 10$^{-4}$ und 10$^{-3}$ g · cm$^2$ · s$^{-1}$ beträgt, um einen Überzug aufzutragen, der aus einer der folgenden Kristallphasen oder einem Gemisch der folgenden Kristallphasen besteht: Phase quadratischer Struktur $B_{50}C_2$, Phase rhomboedrischer Struktur $B_{13}C_2$,

. dass man zuvor die Kennlinie der Überzugshärtenänderung in Abhängigkeit von der Zusammensetzung des gasförmigen Gemisches aus einer Kohlenstoffverbindung und aus einer Borverbindung unter den gewählten Bedingungen der Temperatur, des Druckes und des Massenflusses bestimmt und dann den Wert der Zusammensetzung bestimmt, die der gewünschten Härte entspricht,

. dass man die Zusammensetzung des gasförmigen Gemisches auf den so bestimmten Wert einstellt.

2. Verfahren nach Anspruch 1, dadurch gekennzeichnet, dass die Kennlinie der Überzugshärtenänderung in Abhängigkeit von der Zusammensetzung des gasförmigen Gemisches bestimmt wird, indem man die besagte Zusammensetzung so ändert, dass das atomare Verhältnis C/B des Kohlenstoffs und des Bors in dem gasförmigen Gemisch zwischen ca. 0,05 und 6 beträgt.

3. Verfahren nach einem der Ansprüche 1 oder 2, bei dem von einem gasförmigen Gemisch aus Bortrichlorid und Methan in Gegenwart einer zur Gewährleistung der Reduktion ausreichenden Wasserstoffmenge Gebrauch gemacht wird, wobei das besagte Verfahren dadurch gekennzeichnet ist, dass die Härteänderungskurve bestimmt wird, indem man die veränderlichen Durchflussmengen des Methans Dc und des Bortrichlorids Db mischt, so dass das Verhältnis

$$\frac{100 \cdot Dc}{Db + Dc}$$

zwischen 5 und 85 beträgt, und der Überzug mit der gewünschten Härte dann durch Einstellen des Durchflussmengenverhältnisses auf den der besagten Härte entsprechenden Wert erzielt wird.

4. Verfahren nach einem der Ansprüche 1, 2 oder 3, bei dem die Trägerschicht ein Material der folgenden Gruppe ist: Graphit , Bornitrid, Wolframkarbid, Stahl.

5. Verfahren nach einem der Ansprüche 1, 2, 3 oder 4, bei dem die Trägerschicht an ihrer Oberfläche eine Diffusionssperre umfasst, insbesondere aus Titankarbid, Titannitrid, Siliziumkarbid.

6. Verfahren zur Einstellung der Härte eines Stückes Borkarbid, das darin besteht, dass man im Einklang mit einem der vorstehenden Ansprüche auf einer Trägerschicht einen Überzug mit einer Dicke von mehr als 100 Mikron herstellt und dann die besagte Trägerschicht des besagten Überzugs entfernt, um ein massives Stück Borkarbid der gewünschten Härte zu erhalten.

**Claims**

1. Process for adjusting the hardness of a coating of boron carbide in an area with a hardness approximately between 3 200 and 5 100 kg/mm$^2$ (microhardness HK$_{0.1}$), whereby this process consists in reducing a gaseous mixture of at least one boron compound and at least one carbon compound in the presence of a substrate, the surface of which is heated to a temperature between 800° and 1 200°C, characterised in that:

. one causes the gaseous mixture to sweep the surface of the substrate at a total pressure lower than or equal to 100 millibars, subject to a mean mass flow comprised between 10$^{-4}$ and 10$^{-3}$ g · cm$^2$ · s$^{-1}$, so as to deposit a coating consisting of one of the following crystalline phases or mixture of crystalline phases; phase of quadratic structure B$_{50}$C$_2$, phase of rhombohedral structure B$_{13}$C$_2$,

. one first establishes the curve of coating hardness variation as a function of the composition of the gaseous mixture of carbon compound and boron compound under the chosen conditions of temperature, pressure and mass flow and then determines the value of the composition corresponding to the required hardness,

. one adjusts the composition of the gaseous mixture to the value thus determined.

2. Process according to claim 1, characterised in that the curve of coating hardness variation as a function of the composition of the gaseous mixture is established by varying that composition in such a way that the atomic ratio C/B of the carbon and of the boron in the gaseous mixture is within the range of approximately 0.05 and 6.

3. Process according to one of claims 1 or 2 in which use is made of a gaseous mixture of boron trichloride and methane in the presence of an amount of hydrogen appropriate to ensure the reduction, this process being characterised in that the curve of hardness variation is established by mixing the variable flows of methane Dc and of boron trichloride Db in such a way that the ratio

$$\frac{100 \cdot Dc}{Db + Dc}$$

amounts to between 5 and 85, the coating with the required hardness being then obtained by adjusting the ratio of the flows to the value corresponding to that hardness.

4. Process according to one of claims 1, 2 or 3, in which the substrate is a material pertaining to the following group: graphite, boron nitride, tungsten carbide, steel.

5. Process according to one of claims 1, 2, 3 or 4, in which the substrate comprises on its surface a diffusion barrier, in particular of titanium carbide, titanium nitride, silicon carbide.

6. Process for adjusting the hardness of a piece of boron carbide, which consists in producing, in accordance with one of the preceding claims, a coating with a thickness of more than 100 micron on a substrate and then separating said substrate from said coating in order to obtain a solid piece of boron carbide with the required hardness.

Fig. 1

HK 0,1 kg/mm²

5000

4500

4000

3500

A

C/B (atomique) du dépot

0,04  0,06  0,08  0,10  0,12  0,14  0,16  0,18  0,20

0 214 978

Fig. 2

C/B (atomique) du dépot

0.20
0.18
0.16
0.14
0.12
0.10
0.08
0.06
0.04

10  20  30  40  50  60  70  80

R

0 214 978